# DEMANDE DE BREVET EUROPEEN

(11) **EP 1 146 550 A2**
(43) Date de publication de la demande: **17.10.2001**
(21) Numéro de dépôt: 01400287.7
(22) Date de dépôt: 06.02.2001
(51) Int. Cl.: H01L 21/285

(54) **Procédé de fabrication d'interconnexions dans un circuit intégré**

(30) Priorité: 14.02.2000 FR 0001801
(71) Demandeur: STMicroelectronics SA, 94250 Gentilly Cedex (FR); Koninklijke Philips Electronics N.V., 5621 BA Eindhoven (NL)
(72) Inventeur: Kordic, Srdjan, 38190 Bernin (FR); Torres, Joaquin, 38950 St. Martin le Vinoux (FR); Motte, Pascale, 38119 La Tour du Pin (FR); Descouts, Brigitte, 38240 Meylan (FR)
(74) Mandataire: Casalonga, Axel

(57) **Abrégé**

Le procédé comprend une phase de réalisation, à un niveau de métallisation prédéterminé, d'au moins une piste métallique 7 au sein d'un matériau diélectrique inter-pistes 1 comportant une gravure du matériau diélectrique inter-pistes 1 de façon à former une cavité 4 à l'endroit de ladite piste, le dépôt dans la cavité d'une couche-barrière conductrice 5, le remplissage de la cavité par du cuivre et le dépôt sur le niveau de métallisation prédéterminé d'une couche de nitrure de silicium 8. Entre l'étape de dépôt de la couche-barrière et l'étape de remplissage par le cuivre, on dépose du titane sur une partie au moins de la couche-barrière. Ce titane se transformera en TiSi₂ (60) lors de la diffusion du silicium de la couche de nitrure de silicium 8.

## Description

L'invention concerne la fabrication des circuits intégrés, et plus particulièrement la réalisation des pistes métalliques utilisant un procédé du type "damascène", selon une dénomination bien connue de l'homme du métier.

Un procédé de damascène peut être effectué selon plusieurs variantes. Dans la variante dite "simple damascène", on réalise la piste en ménageant une cavité dans le diélectrique interpiste disposé au niveau de métallisation considéré, puis en remplissant la cavité par un métal de remplissage, par exemple du cuivre, après avoir déposé dans le fond et sur les flancs de la cavité une couche-barrière conductrice, par exemple en nitrure de tantale.

La fabrication du circuit intégré comporte également le dépôt d'une couche d'encapsulation, typiquement en nitrure de silicium, sur le niveau de métallisation. Ce dépôt s'effectue de façon classique à haute température, typiquement à 400°C. Par ailleurs, outre ce traitement thermique, la fabrication d'un circuit intégré nécessite d'autres traitements thermiques, par exemple après chaque dépôt d'oxyde. Or, lors de ces traitements thermiques, et notamment lors du dépôt à 400°C du nitrure de silicium, de petites quantités de silicium peuvent diffuser dans les pistes en cuivre à partir de la couche d'encapsulation en nitrure de silicium. Il en résulte alors une augmentation significative de la résistivité des pistes métalliques.

Actuellement, cet effet indésirable sur la résistance des pistes peut être évité en exposant le niveau de métallisation à un plasma d'ammoniaque avant le dépôt de la couche d'encapsulation en nitrure de silicium. Ceci permet d'empêcher la diffusion ultérieure du silicium. Cependant, un tel traitement à base de plasma peut endommager les transistors du circuit intégré.

L'invention vise à apporter une solution à ce problème et propose une solution radicalement différente pour éviter l'augmentation de la résistance des pistes métalliques due à une diffusion de silicium dans le cuivre.

L'invention propose donc un procédé de fabrication d'un circuit intégré, comprenant une phase de réalisation, à un niveau de métallisation prédéterminé, d'au moins une piste métallique au sein d'un matériau diélectrique interpiste, cette phase de réalisation comportant une gravure du matériau diélectrique interpiste de façon à former une cavité à l'endroit de ladite piste, le dépôt dans la cavité d'une couche-barrière conductrice, par exemple en nitrure de tantale, le remplissage de la cavité par du cuivre et le dépôt sur le niveau de métallisation prédéterminé d'une couche de nitrure de silicium.

Selon une caractéristique générale de l'invention, la phase de réalisation de la piste métallique comprend en outre, entre l'étape de dépôt de la couche-barrière et l'étape de remplissage par le cuivre, un dépôt de titane sur une partie au moins de la couche-barrière.

Ainsi, lorsque le silicium de la couche de nitrure de silicium diffuse dans les pistes en cuivre, sous des budgets thermiques importants, par exemple supérieur ou égal à 400°C, le silicium forme avec le titane un siliciure de titane TiSi₂. Le silicium qui diffuse dans le cuivre est ainsi piégé par le titane, ce qui permet de préserver la basse résistivité du cuivre.

D'une façon générale, il n'est pas nécessaire que la couche de titane épouse parfaitement les parois de la cavité ni qu'elle soit parfaitement continue, puisque son seul but est d'extraire du cuivre le silicium ayant diffusé (par transformation en siliciure de titane). Ainsi, il est possible d'effectuer ce dépôt de titane par une simple pulvérisation, par exemple à l'aide d'un plasma d'argon qui vient frapper une cible en titane.

Par ailleurs, le dépôt de titane par pulvérisation s'avère suffisant pour déposer des particules de titane à la partie supérieure de la cavité, ce qui présente l'avantage d'être le plus proche possible de la couche de nitrure de silicium.

Selon un mode de mise en oeuvre de l'invention, préalablement au remplissage par le cuivre, on effectue une gravure ionique non réactive du titane déposé dans la cavité, avec un flux de plasma perpendiculaire au fond de la cavité. Ceci permet de retirer le titane du fond de la cavité et d'éviter ainsi le risque d'un accroissement de la résistance de la ligne (piste). Et, cette gravure ionique non réactive avec un flux de plasma perpendiculaire au fond de la cavité, permet de laisser subsister les particules de titane sur les flancs verticaux de la cavité, et en particulier celles proches du bord supérieur de la cavité.

D'autres avantages et caractéristiques de l'invention apparaîtront à l'examen de la description détaillée d'un mode de mise en oeuvre, nullement limitatif, et des dessins annexés, sur lesquels :
- les figures 1a à 1h illustrent schématiquement un mode de mise en oeuvre du procédé selon l'invention, plus particulièrement dans le cadre d'un procédé simple damascène.

Sur la figure 1a, la référence 1 désigne une couche d'un matériau diélectrique inter-pistes, par exemple du SiO₂ formé à partir de tétraorthosilicate d'éthyle (Si(OC₂H₅)₄; TEOS en langue anglaise)). C'est à l'intérieur de cette couche 1 que l'on va réaliser les pistes métalliques du niveau de métallisation n.

Cette couche diélectrique 1 repose sur une couche d'encapsulation 2, ayant une épaisseur de l'ordre de 120 nm, et typiquement en nitrure de silicium SiN ou plus généralement en SiₓN_{y}. Cette couche d'encapsulation 2 est déposée sur une couche d'un matériau diélectrique inter-niveaux, par exemple également du SiO₂ formé à partir de tétraorthosilicate d'éthyle, et qui sépare le niveau de métal n du niveau de métal inférieur n-1. Cette couche de diélectrique inter-niveaux a typiquement une épaisseur de 800 nm.

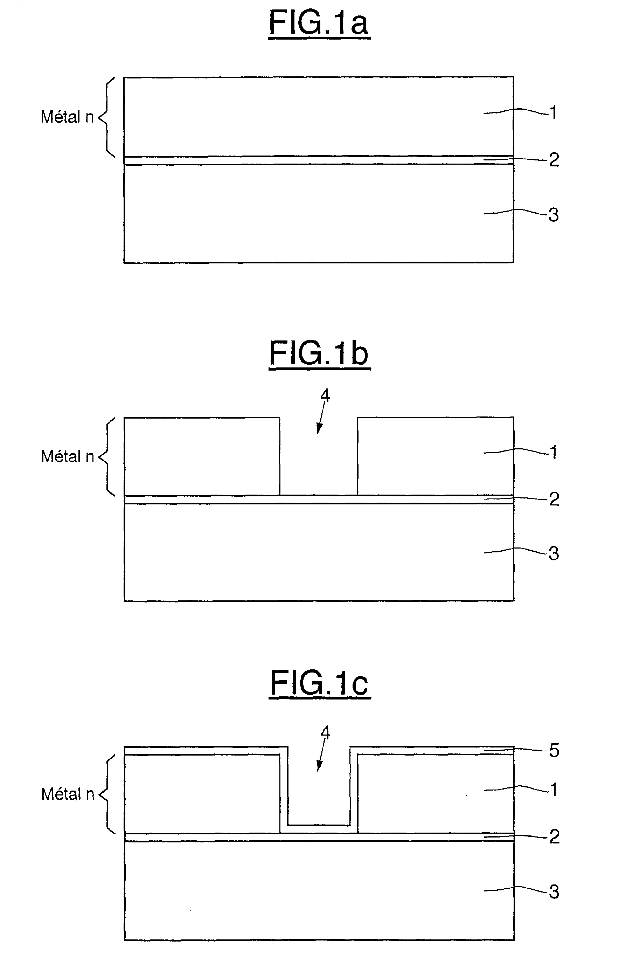

L'étape suivante (figure 1b) consiste, en utilisant des méthodes classiques de photo-lithographie, à effectuer une gravure du matériau diélectrique inter-pistes 1, avec arrêt sur la couche d'encapsulation 2, de façon à ménager des cavités 4 (une seule de ces cavités est représentée sur la figure 1b) à l'endroit des futures pistes métalliques.

Il convient de noter ici que la couche d'encapsulation 2 sert, d'une part à éviter une contamination du diélectrique inter-niveaux par le cuivre de la piste du niveau n, d'autre part de couche d'arrêt pour la gravure de la cavité.

On dépose ensuite (figure 1c), de façon classique, une couche-barrière conductrice 5, typiquement en nitrure de tantale ou bien en nitrure de titane. Cette couche, d'une épaisseur de quelques dizaines de nanomètres, par exemple 25 nm, sert de barrière à la diffusion de particules de cuivre dans le diélectrique inter-pistes.

On effectue ensuite (figure 1d) un dépôt de titane par pulvérisation, par exemple en utilisant un plasma à base d'argon qui vient frapper une cible en titane à température ambiante sous une pression de 1 Torr. Les particules de titane 6 sont alors pulvérisées sur les flancs et le fond de la cavité 4 ainsi que sur la surface de la couche-barrière 5.

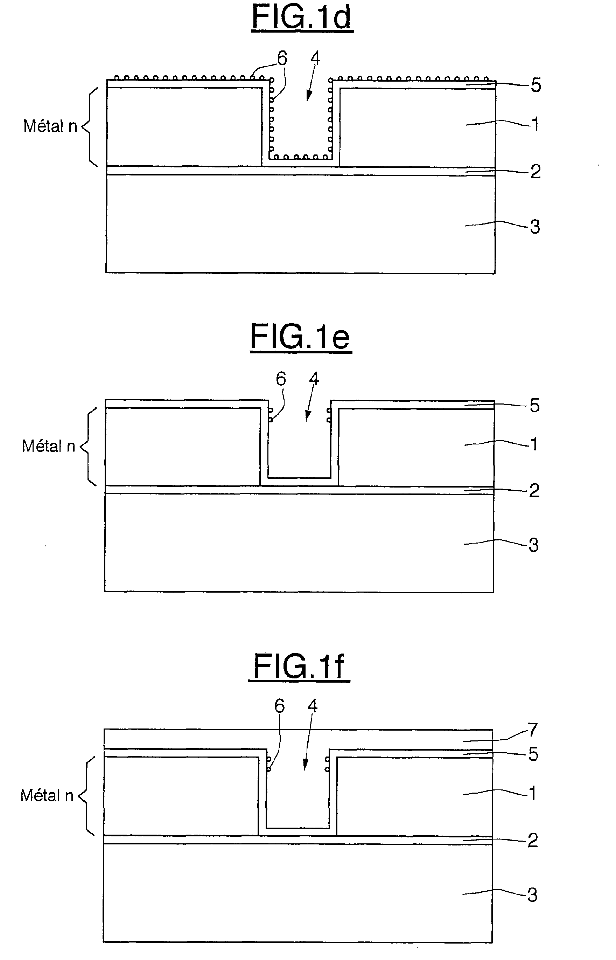

Quoique non indispensable, on effectue ensuite avantageusement (figure 1e) une gravure ionique non réactive du titane 6 pulvérisé à l'étape précédente, de façon à retirer les particules de titane notamment dans le fond de la cavité. Cette gravure ionique non réactive a également pour conséquence de retirer le titane sur la surface supérieure de la couche-barrière 5. Une telle gravure ionique non réactive est classique pour l'homme du métier. Elle s'effectue ainsi typiquement avec un flux d'ions dirigé perpendiculairement au fond de la cavité 4.

Cette étape de nettoyage permet de retirer le titane du fond de la cavité, ce qui évitera un risque d'accroissement de la résistance de la piste métallique ultérieure.

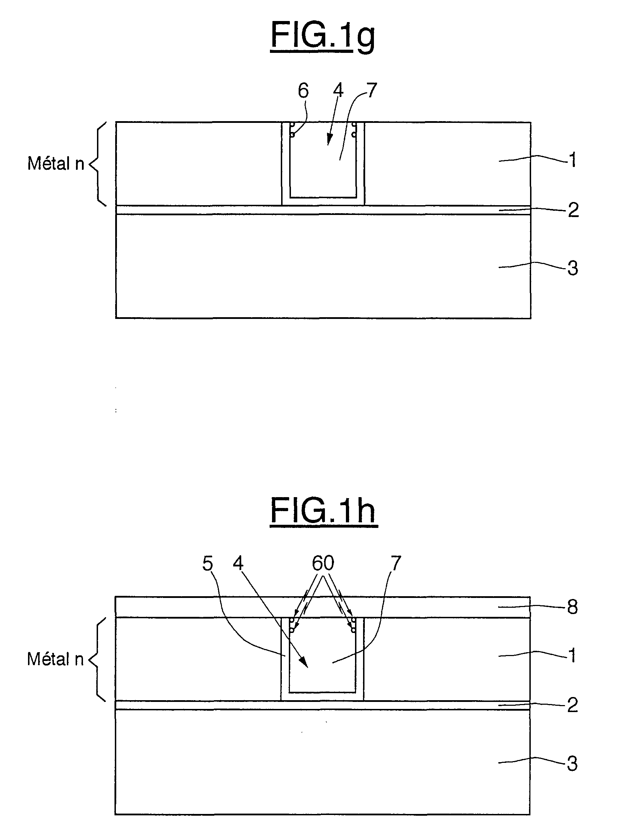

On procède ensuite (figure 1f) à un dépôt classique de cuivre 7, puis on effectue un polissage mécano-chimique classique de façon à obtenir la configuration illustrée sur la figure 1g. Ce polissage permet également avantageusement de retirer des résidus éventuels de titane, qui auraient pu subsister après la gravure ionique non réactive du titane.

On procède ensuite (figure 1h) au dépôt d'une autre couche d'encapsulation 8 en nitrure de silicium. Ce dépôt s'effectue classiquement sous un budget thermique de l'ordre de 400°C, ce qui provoque une diffusion de silicium dans le cuivre de la cavité 4. Cependant, le silicium ainsi diffusé est piégé par les particules de titane et se transforme en un siliciure de titane TiSi₂ 60, ce qui permet de préserver la faible résistivité du cuivre.

L'invention présente donc l'avantage de ne pas affecter la faible résistivité du cuivre des pistes métalliques tout en évitant de causer des dommages aux transistors du circuit intégré.

Bien entendu, l'invention n'est pas limitée à la variante dite "simple damascène" qui vient d'être décrite. Elle s'applique également notamment à la variante dite "double damascène auto-aligné" dans laquelle on réalise simultanément la gravure des cavités des connexions métalliques verticales (communément appelées par l'homme du métier "vias") et des cavités des futures pistes du niveau de métallisation supérieur.

## Revendications

1. Procédé de fabrication d'un circuit intégré, comprenant une phase de réalisation, à un niveau de métallisation prédéterminé, d'au moins une piste métallique (7) au sein d'un matériau diélectrique inter-pistes (1) comportant une gravure du matériau diélectrique inter-pistes (1) de façon à former une cavité (4) à l'endroit de ladite piste, le dépôt dans la cavité d'une couche-barrière conductrice (5), le remplissage de la cavité par du cuivre et le dépôt sur le niveau de métallisation prédéterminé d'une couche de nitrure de silicium (8), **caractérisé par le fait que** la phase de réalisation de la piste métallique comprend en outre entre l'étape de dépôt de la couche-barrière et l'étape de remplissage par le cuivre, un dépôt de titane (6) sur une partie au moins de la couche-barrière.

2. Procédé selon la revendication 1, **caractérisé par le fait que** le dépôt de titane (6) s'effectue par pulvérisation.

3. Procédé selon la revendication 1 ou 2, **caractérisé par le fait que**, préalablement au remplissage par le cuivre, on effectue une gravure ionique non réactive du titane déposé, avec un flux de plasma perpendiculaire au fond de la cavité (4).
